(19) **Europäisches Patentamt**

**European Patent Office**

**Office européen des brevets**

(11) **EP 0 923 142 B1**

(12) **FASCICULE DE BREVET EUROPEEN**

(45) Date de publication et mention
de la délivrance du brevet:
**20.08.2003 Bulletin 2003/34**

(51) Int Cl.⁷: **H01L 39/10**, H01L 27/18

(21) Numéro de dépôt: **98403002.3**

(22) Date de dépôt: **01.12.1998**

(54) **Cellule de détection supraconductrice à effet tunnel**

Supraleitende Tunneleffektdetektorzelle

Superconducting tunneling detector cell

(84) Etats contractants désignés:
**DE ES GB IT**

(30) Priorité: **05.12.1997 FR 9715384**

(43) Date de publication de la demande:
**16.06.1999 Bulletin 1999/24**

(73) Titulaire: **AGENCE SPATIALE EUROPEENNE**
**F-75738 Paris Cedex 15 (FR)**

(72) Inventeurs:
• **Peacock, Anthony**
**2211 DD Noordwijkerhout (NL)**
• **Venn, Robert**
**Kingston, Cambridge CB3 7N (GB)**

(74) Mandataire: **Jacquard, Philippe Jean-Luc et al**
**Cabinet ORES,**
**36,rue de St Pétersbourg**
**75008 Paris (FR)**

(56) Documents cités:
**EP-A- 0 375 465          FR-A- 2 696 544**

**Description**

La présente invention a pour objet une cellule de détection comportant des dispositifs supraconducteurs à effet tunnel organisés suivant un réseau à deux dimensions et disposés sur un substrat commun, chaque dispositif supraconducteur comprenant une jonction supraconductrice à effet tunnel, connectée électriquement à une plage de connexion de base et à une plage de connexion supérieure.

Un tel dispositif est connu de l'article de E. ESPOSITO et Collaborateurs intitulé "Development of a dark matter detector using series arrays or superconducting tunnel junctions" publié dans "Nuclear Instruments and Methods in Physics Research" A370 (1996) p.31 à 33.

Des réseaux de dispositifs à effet tunnel Josephson sont également connus :

- de l'article de F. MÜLLER et Collaborateurs intitulé "Performance of Josephson Array Systems Related to Fabrication Techniques and Design", paru dans IEEE Transactions on Applied Superconductivity vol.5 n°2 (juin 1995),
- et du Brevet Français FR 2 696 544, intitulé "Cellule de détection, Détecteur, Capteur et Spectroscope", qui a été déposé le 5 octobre 1992 et délivré le 23 juin 1995 à la Demanderesse.

La présente invention a pour objet une cellule de détection à réseau de jonctions Josephson qui présente une densité d'intégration élevée et qui permette en particulier de réaliser un dispositif de prise de vue supraconducteur, par exemple une caméra supraccnductrice.

L'idée de base de l'invention est d'assurer une séparation physique entre les dispositifs à effet tunnel tout en assurant une connexion électrique de base qui permette de réduire les contacts de base à un contact commun à un groupe de dispositifs ou bien à un seul contact pour l'ensemble des dispositifs.

L'invention concerne ainsi une cellule de détection de photons comportant des dispositifs supraconducteurs à effet tunnel organisés suivant un réseau à deux dimensions et disposés sur un substrat commun, chaque dispositif supraconducteur comprenant une jonction supraconductrice à effet tunnel, connectée électriquement à une plage de connexion de base et à une plage de connexion supérieure caractérisée en ce que les dispositifs supraconducteurs sont séparés entre eux par une région de tranchée s'étendant jusqu'à y compris la plage de connexion de base de manière à assurer une séparation physique entre des dispositifs supraconducteurs adjacents et à délimiter des plages de connexion de base individuelles disposées entre ladite jonction et le substrat et en ce qu'au moins une plage de connexion de base individuelle est connectée électriquement à au moins une plage de connexion de base d'un dispositif supraconducteur adjacent par une région de pont localisée.

Préférentiellement, au moins une dite région de pont comporte deux appendices dont les extrémités sont connectées électriquement entre elles par une plage localisée. En particulier, cette connexion est réalisée à l'aide d'un matériau ayant une largeur de bande interdite $2\Delta$ supérieure (ou à la rigueur égale) à celle du matériau constituant lesdites plages de conduction de base individuelles et les appendices.

Au moins une dite région de pont peut présenter une largeur comprise entre 0,5 micron et 2 microns et de préférence entre 0,5 et 1 micron.

La largeur d'au moins une dite région de pont peut être inférieure ou égale à la largeur de ladite région de tranchée.

Selon un mode de réalisation préféré, la plage de connexion de chaque dispositif supraconducteur est connectée par une dite région de pont aux plages de connexion de chaque dispositif supraconducteur qui lui est adjacent.

Avantageusement, les dispositifs supraconducteurs sont des mésas en forme de quadrilatère (de préférence des carrés) et les dispositifs supraconducteurs situés dans des rangées adjacentes sont décalés les uns par rapport aux autres d'une distance inférieure à leur pas, et les plages de connexion supérieures présentent des terminaisons conductrices disposées sensiblement dans le prolongement des diagonales desdits quadrilatères. De ce fait, les terminaisons conductrices peuvent être connectées électriquement dans le prolongement des diagonales des jonctions respectives (ce qui est préférable d'un point de vue magnétique), un meilleur espacement des terminaisons est obtenu, et de plus il n'existe qu'une interaction capacitive entre les différentes jonctions et leurs terminaisons.

D'autres caractéristiques et avantages de l'invention apparaîtront mieux à la lecture de la description qui va suivre, donnée à titre d'exemple non limitatif, en liaison avec les dessins ci-annexés, dans lesquels :

- la figure 1 représente un mésa de forme carrée constituant un dispositif supraconducteur à effet tunnel ;
- la figure 2a représente en vue de dessus une portion d'une région de cellule selon l'invention ;
- les figures 2b à 2d sont des détails de la figure 2a avant et après pontage par des régions de pont présentant des plages localisées ;
- la figure 3 représente en vue de dessus un détail d'un réseau de cellules selon un mode de réalisation préféré de l'invention ;
- la figure 4a représente en vue de dessus une cellule de détection selon la figure 3, la figure 4b illustrant son principe de connexion pour former un dispositif tel qu'une caméra surpaconductrice.

On rappelera tout d'abord brièvement que les détecteurs supraconducteurs à effet tunnel présentent deux avantages importants par rapport aux détecteurs semi-conducteurs classiques.

Tout d'abord, et en vertu de la théorie de Bardeen, Cooper et Schrieffer, l'écart d'énergie, ou largeur de bande interdite $2\Delta$, entre l'état non excité, représenté par des paires de Cooper en état ordonné, et le premier état excité, contenant des paires de Cooper brisées que l'on appelle également des "quasiparticules", est en général plus de mille fois plus faible que l'écart d'énergie entre la bande de valence et la bande de conduction d'un semi-conducteur.

D'autre part, l'énergie de Debye $\Omega_D$ est très supérieure à l'écart d'énergie $2\Delta$ ce qui permet à des phonons générés par photoabsorption de briser les paires de Cooper et de créer des charges libres. Pour l'aluminium massif, $2\Delta$ est de l'ordre de 170μeV alors que $\Omega_D$ est de l'ordre de 37μeV.

Dans un supraconducteur et à une température de transition donnée, les électrons de conduction interagissent avec le réseau par une interaction positive électron-phonon, ce qui surmonte leur répulsion mutuelle de Coulomb, d'où la formation de paires d'électrons, et ce sont ces paires de Cooper qui transportent le courant électrique.

La température à laquelle intervient le changement de phase lorsque les électrons commencent à s'organiser sous forme de condensats de paires de Cooper est appelée la température critique Tc. L'énergie de Debye peut être interprétée comme étant l'énergie maximale associée aux modes vibratoires du réseau.

L'absorption d'un photon de longueur d'onde $\lambda$ (nm) par un supraconducteur se traduit par une série de processus rapides au cours desquels l'énergie $\gamma$(eV) du photon est convertie en paires de Cooper brisées (quasiparticules) et en phonons. Pour un superconducteur d'usage courant tel que le Niobium, le processus de conversion intervient environ 2 nanosecondes après l'existence d'un déséquilibre de distribution entre les quasiparticules et les phonons. A une température suffisamment basse, ce l'ordre du dixième de la température critique Tc(°K), le nombre initial de quasiparticules $N_o$ créé par l'absorption d'un photon de longueur d'onde $\lambda$ peut dépasser la population induite thermiquement et elle est inversement proportionnelle à la longueur d'onde $\lambda$. Pour la plupart des semiconducteurs,

$$N_o(\lambda) \sim 7 10^5 / \lambda \Delta(T).$$

L'énergie moyenne nécessaire à la création d'une seule quasiparticule dans le Niobium et dans l'Etain est de l'ordre respectivement de $1,75\Delta$ et de $1,7\Delta$. La résolution limite de Fano a pour valeur :

$$d\lambda_F(nm) \sim 2,8 \ 10^{-3} \lambda^{3/2}[F(\Delta T)]^{1/2}$$

formule dans laquelle l'écart $\Delta$ est exprimé en meV et $\lambda$ en nanomètres (nm).

Les valeurs $\varepsilon \sim 1,75\Delta$ et le facteur de Fano $F \sim 0,2$ s'appliquent à la plupart des semiconducteurs élémentaires. Pour le Niobium, le facteur de Fano F est de l'ordre de 0,22 et pour l'étain il est de l'ordre de 0,19.

Les deux équations ci-dessus sont fondamentales. Elles définissent la charge générée dans un supraconducteur à une température T, ayant un écart d'énergie $\Delta$, lors de la photoabsorption d'un photon de longueur d'onde $\lambda$. Pour un supraconducteur tel que le Tantale à une température de Tc/10, avec Tc=4,5°K, la charge initiale $N_o(\lambda)$ générée par la photoabsorption d'un photon dont la longueur d'onde $\lambda$ est de 500nm est de l'ordre de 2000 quasiparticules. La limite de résolution de Fano correspondante du Tantale est dans ce cas de l'ordre de 12nm.

Ces deux équations peuvent être généralisées à tout élément supraconducteur, ou à un composé particulier, ayant une température critique Tc en appliquant la relation d'approximation BCS à la limite du couplage faible qui lie la largeur de bande d'un matériau au zéro absolu à sa valeur à la température Tc, par exemple $\Delta=1,75kTc$, k étant la constante de Boltzmann.

Il vient alors :

$$N_o(\lambda) \sim 4,6.10^6 / \lambda Tc$$

et

$$d\lambda_F(nm) \sim 5 10^{-4} \lambda^{3/2} Tc^{1/2}$$

Pour le Tantale, la résolution, pour la ligne alpha de Lyman ultraviolette à 120 nm jusqu'à l'infrarouge proche, varie entre respectivement environ 1,5 nm et environ 30 nm, $N_o(\lambda)$ variant depuis environ 8000 et environ 1000 électrons.

Pour un supraconducteur ayant une valeur de Tc faible, par exemple le Hafnium, la résolution de Fano varierait alors dans la même bande passante entre environ 0,2 nm et environ 15 nm. Bien entendu, le prix à payer pour une telle résolution est la température d'utilisation du supraconducteur qui doit être de l'ordre de $0,1T_C$ à $0,2T_C$.

Par opposition à un détecteur à semiconducteur, tel qu'un CCD, un détecteur supraconducteur ne peut pas retenir une charge électrique.

Pour détecter les quasiparticules qui sont produites en excédent lors d'un processus de photoabsorotion, il convient d'assurer qu'elles transitent par effet tunnel d'un film supraconducteur mince S1 dans lequel elles sont générées à un autre film supraconducteur mince S2, à travers une couche isolante mince I. La probabilité d'obtention de l'effet tunnel est optimale lorsque la barrière isolante est très mince, ce l'ordre de 1nm, c'est-à-dire de seulement quelques couches atomiques. Cette structure SIS constitue une jonction supraconductrice à effet tunnel également appelée jonction Josephson.

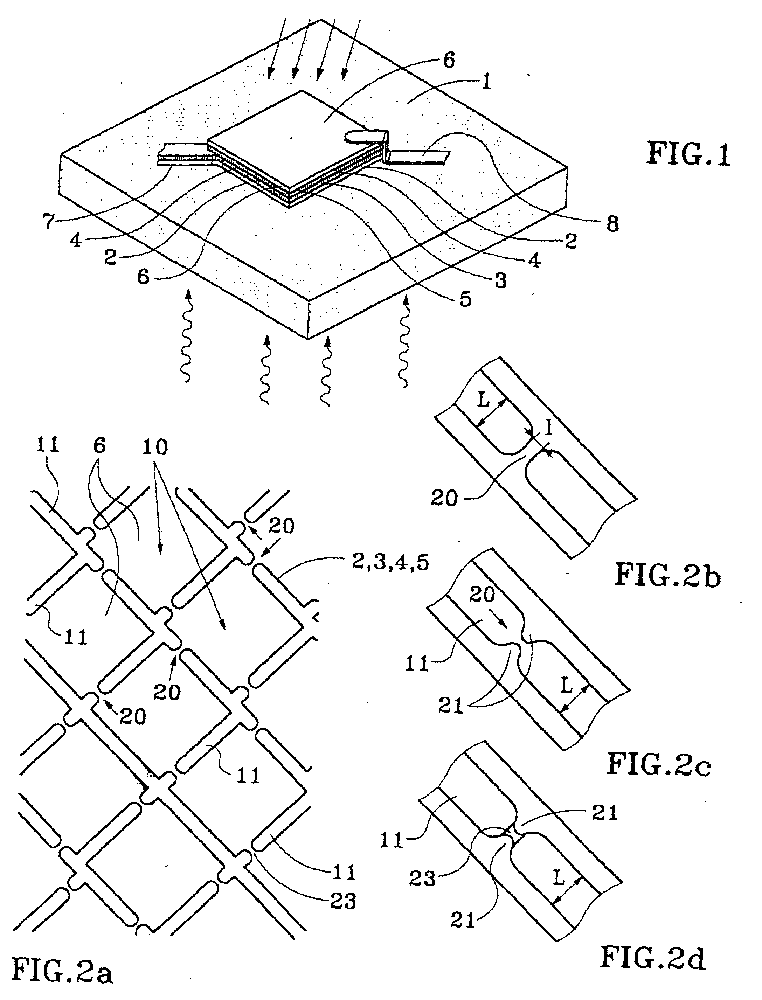

Un champ magnétique de faible intensité est appliqué parallèlement à la barrière formant jonction (voir figure 1) de manière à annuler le courant Josephson qui provient de la transition par effet tunnel de paires de Cooper pour une tension de polarisation nulle. L'application d'une tension de polarisation Vb inférieure à $2\Delta/e$, e étant la charge de l'électron, permet d'assurer que les seules transitions qui interviennent par effet tunnel proviennent du transfert de quasiparticules d'un film à l'autre. Le flux de quasiparticules pendant un temps t produit un courant électrique mesurable qui peut être détecté au dessus du niveau des fluctuations du courant sous-jacent à l'aide d'un amplificateur de charges électriques. Le courant sous-jacent provient soit d'une population thermique résiduelle de quasiparticules générant un courant de bruit thermique, soit de courants de fuite. L'amplitude des impulsions ce courant est généralement proportionnelle à l'énergie du photon incident, alors que le temps de montée de l'imoulsion permet une validation d'un événement.

Le réseau à deux dimensions d'une cellule de direction selon l'invention comprend des dispositifs supraconducteurs individuels 10 disposés sur un substrat 1 par exemple en saphir ou en $MgF_2$ dont chacun comporte (cf. fig.1) :

- une plage individuelle de connexion de base 2 de forme carrée et constituée par un film de Tantale ($\Delta=0,7meV$) épitaxié sur le substrat 1 en saphir.
- une jonction supraconductrice de forme carrée comportant une couche tunnel 4 en $AlO_x$ de forme carrée et d'épaisseur environ, 1 nm disposée entre deux couches 3 et 5 en Aluminium ($\Delta=0,17meV$) de forme carrée.
- une plage individuelle de connexion supérieure 6 en Tantale ($\Delta=0,7meV$) également de forme carrée.

La figure 1 reorésente à titre d'illustration un dispositif supraconducteur individuel dont la connexion de base est assurée par une terminaison de base 7 qui prolonge la plage 2 et la couche 3 dans une diagonale du dispositif, et par une terminaison 8 en contact avec la plage 6.

Dans le réseau selon l'invention, on évite de mettre en oeuvre une connexion de base pour chaque dispositif individuel 10.

Comme représenté aux figures 2a, 2c et 2d, les dispositifs élémentaires 10 du réseau présentent chacun une forme carrée et sont séparés par des tranchées 11. Ces tranchées 11 s'étendent depuis les plages 6 jusqu'à y compris les plages individuelles 2 de connexion de base.

Selon l'invention, ces tranchées 11 permettent de séparer physiquement les dispositifs individuels 10, et les plages individuelles 2 sont électriquement connectées entre elles par des régions de pont 20. Les tranchées 11 s'étendent donc jusqu'au substrat 1 à l'exception des régions de pont 20. En particulier, comme représenté aux figures 2c et 2d, ces régions de pont 20 sont ouvertes et présentent des appendices 21 se faisant face et appartenant à deux plages individuelles 2 adjacentes et qui sont pontées par une plage localisée 23 réalisée en un matériau présentant une largeur de bande interdite $2\Delta$ supérieure (ou à la rigueur égale) à celle du matériau constituant les plages 2 de connexion de base. Par exemple, pour des plages 2 et des appendices 21 en Tantale, les plages localisées 23 peuvent être en Niobium ($\Delta=1,525meV$).

La mise en oeuvre de plages localisées 23 en un matériau de largeur de bande interdite supérieure à celle du matériau constituant les plages de connexion de base permet aux plages 23 de remplir la fonction de miroirs qui renvoient les charges vers les dispositifs individuels constituant les points image ou pixels de réseau, ce qui permet d'éviter l'existence de pertes entre les différents pixels.

La taille des dispcsitifs individuels peut être par exemple de l'ordre de 50x50 microns (ou moins), cette taille permettant de minimiser le courant thermique à des températures de l'ordre de 0,3 à 0,4°K, ainsi que de réduire le bruit capacitif.

Les contacts supérieurs sont de préférence disposés sur les coins des dispositifs individuels pour satisfaire aux critères relatifs aux champs magnétiques.

Les dimensions des interconnexions sort limitées par les techniques actuelles de photolithographie à des tailles de l'ordre de 1,5 à 2 microns. Le procédé mis en oeuvre limite la largeur des terminaisons de contact supérieur et le nombre de dispositifs par rangée sur un substrat de taille donnée, ce qui fait que la taille minimale des dispositifs individuels est, avec les techniques actuelles de photolithographie, de l'ordre ce 20 x 20 microns, et que la largeur des bandes de métallisation peut être de l'ordre d'un micron.

L'interconnexion électrique des plages individuelles 2 des dispositifs individuels a pour effet que le film formant contact de base est commun du point de vue électrique à tous les dispositifs individuels (ou à un groupe de dispositifs individuels), ce qui permet de diminuer les ponts thermiques, car il n'est plus besoin de faire sortir d'un cryostat qu'une seule liaison, voire deux liaisons et en tous cas un nombre limité de liaisons de contact de base, au lieu d'une liaison de contact de base pour chaque dispositif individuel.

La présence des tranchées 11 et des régions de pont 20 permet d'obtenir à la fois une séparation physique entre les dispositifs supraconducteurs individuels et une interconnexion des plages conductives individuelles 2. Il est possible, avec les techniques photolithographiques actuelles de réaliser des régions de pont 20 de largeur aussi faible que 0,5 micron à 1 micron. En pratique, les régions de pont 20 et notamment les plages 23 peuvent avoir une largeur 1 comprise entre 0,5

En ce qui concerne la largeur L des tranchées 11, elle sera choisie aussi faible que le permet le procédé de photolithographie. Avec les techniques actuelles, la valeur recommandée est de 2 microns.

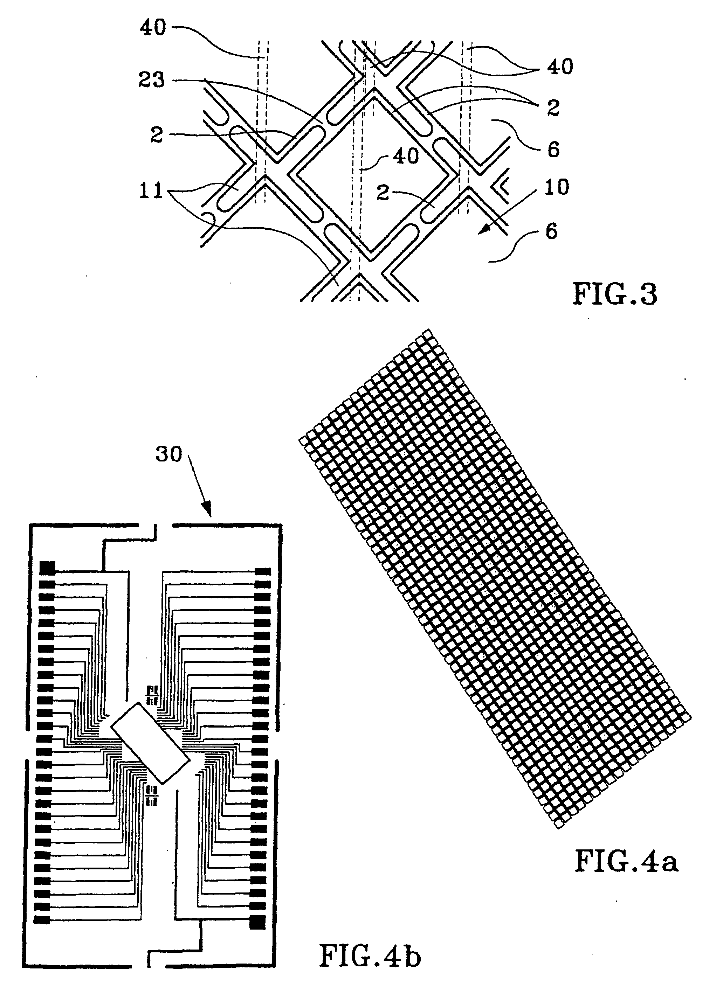

Les figures 3 et 4a représentent une cellule de détection présentant 18 x 50 dispositifs individuels organisés suivant deux sous-réseaux accolés de 9 x 50 dispositifs individuels, d'où la présence de deux terminaisons de connexion de base. Chacun des dispositifs forme un carré de 50 x 50 microns, et les régions de tranchée 11 ont une largeur L de 4 microns, d'où un pas P de 54 microns.

Dans le sens longitudinal du substrat, les rangées adjacentes sont décalées de 6 microns, ce qui fait que les rangées espacées modulo 10 fois le pas F sont alignées. La présence de ce décalage, qui est de préférence égale à P/n, n étant un nombre entier, permet de disposer les terminaisons de connexion supérieures dans l'alignement des diagonales des jonctions Josephson constituant les dispositifs individuels. Le décalage doit être suffisant pour permettre de ménager entre les terminaisons un espace suffisant relativement au procédé mis en oeuvre. Dans ces conditions, une terminaison 40 d'un dispositif quelconque est situé dans l'alignement de la diagonale dudit dispositif sans être situé dans l'alignement de la diagonale d'un autre dispositif (Fig.3).

Pour interconnecter les dispositifs individuels de la figure 4a, on dispose de chaque côté deux séries ce 225 terminaisons comportant 113 terminaisons externes et 112 terminaisons internes, soit en tout 900 terminaisons supérieures, avec un pas de 60 microns (54 + 6) encre les terminaisons. Pour simplifier la représentation graphique, la figure 4b illustre le cas de la connexion d'un réseau de 6 x 9 dispositifs individuels, comprenant deux sous-réseaux de 3 x 9 dispositifs soit 54 terminaisons supérieures, et deux contacts de base, réalisée selon le même principe.

Selon un procédé de fabrication d'une cellule de détection selon l'invention, les plages 2 de connexion de base et les plages 6 de connexion supérieure sont en Tantale, dont la largeur de bande interdite $2\Delta$ est supérieure à celle de l'Aluminium, qui constitue les couches 3 et 5 entre lesquelles est disposée la couche isolante en oxyde d'Aluminium. La cellule est réalisée sur un substrat en saphir à l'aide d'un procédé de photolithographie de classe 1 micron connu en soi, par exemple des articles précités de E. ESPOSITO, ou ce F. MÜLLER. On réalise tout d'abord les plages 2 et les régions de pont 20 (Fig.2b), à l'aide d'un premier masque. On réalise ensuite les plages carrées 3, 4, 5 et 6, puis une couche de $SiO_2$ à l'aide d'un deuxième masque. Comme représenté à la figure 3, les plages 2 sont légèrement plus grandes dans les deux dimensions (d'un micron environ) que les plages 3, 4 et 5, de manière à faciliter la réalisation ultérieure des plages localisées 23.

Les régions de pont fermées 20 en Tantale (Fig.2b) sont ensuite découpées pour obtenir les appendices 21 (Fig.2c). Cette découpe peut s'effectuer par photolithographie.

Les plages localisées 23 en Niobium, dont la largeur de bande interdite $2\Delta$ est supérieure à celle du Tantale, sont ensuite déposées par photolithographie (Fig. 2d).

Ensuite, des ouvertures d'environ 1x1 micron sont réalisées par attaque chimique à travers la couche de $SiO_2$. Chaque ouverture est carrée et s'étend jusqu'à la plage correspondante 6 qui n'est pas attaquée. On dépose ensuite par projection ("sputtering") du Niobium polycristallin à travers un masque sous forme de bandes de largeur par exemple 1 micron par dessus la couche de $SiO_2$, et chaque bande vient en contact avec la face supérieure de la plage 6 correspondante, de manière connue en soi. Ceci permet de réaliser toutes les connexions électriques du réseau avec un matériau dont la largeur de bande interdite $2\Delta$ est inférieure à celle du matériau constituant les plages conductrices individuelles 6.

Des plages dorées sont ensuite déposées sur le bord du substrat 1 pour permettre la connexion des fils de connexion aux terminaisons d'un support 30.

## Revendications

**1.** Cellule de détection de photons comportant des dispositifs supraconducteurs à effet tunnel organisés suivant un réseau à deux dimensions et disposés sur un substrat commun, chaque dispositif supraconducteur comprenant une jonction supraconductrice à effet tunnel, connectée électriquement à une plage de connexion ce base et à une plage de connexion supérieure **caractérisée en ce que** les dispositifs supraconducteurs sont séparés entre eux par une région de tranchée (11) s'étendant jusqu'à y compris la plage de connexion de base de manière à assurer une séparation physique entre ces dispositifs supraconducteurs adjacents et à délimiter des plages de connexion de base individuelles (2) disposées entre ladite jonction (3,4,5) et le substrat (1) et **en ce qu'**au moins une plage de connexion de base individuelle (2) est connectée électriquement à au moins une plage de connexion de base d'un dispositif supraconducteur adjacent par une région de pont localisée (20).

**2.** Cellule selon la revendication 1 **caractérisée en ce qu'**au moins une dite région de pont (20) comporte deux appendices (21) dont les extrémités sont connectées électriquement entre elles par une plage localisée (23).

**3.** Cellule selon la revendication 2 **caractérisée en ce que** ladite plage localisée (23) est réalisée en un matériau ayant une largeur de bande interdite supérieure ou égale à celle du matériau constituant lesdites plages de connexion de base (2) et lesdits appendices (21).

4. Cellule selon une des revendications 1 à 3 **caractérisée en ce qu'**au moins une dite région ce pont (20,23) présente une largeur comprise entre 0,5μ et 2μ et de préférence entre 0,5μ et 1μ.

5. Cellule selon une des revendications précédentes **caractérisée en ce que** la largeur d'au moins une dite région de pont (20,23) est inférieure ou égale à la largeur de ladite région de tranchée (11).

6. Cellule selon une des revendications précédentes **caractérisée en ce que** la plage de connexion (2) de chaque dispositif supraconducteur (10) est connectée par une dite région de pont (20) aux plages de connexion (2) de chaque dispositif supraconducteur (10) qui lui est adjacent.

7. Cellule selon une des revendications précédentes **caractérisée en ce que** les dispositifs supraconducteurs (10) sont des mésas de forme de quadrilatère et **en ce que** les dispositifs supraconducteurs (10) situés dans des rangées adjacentes sont décalés les uns par rapport aux autres d'une distance inférieure à leur pas (P), et **en ce que** les plages de connexion supérieures (6) présentent des terminaisons conductrices disposées dans le prolongement des diagonales desdits quadrilatères.

8. Cellule selon une des revendications précédentes **caractérisée en ce que** les dispositifs supraconducteurs (10) forment des mésas de forme carrée.

9. Dispositif de prise de vue **caractérisé en ce qu'**il comporte une cellule de détection selon une des revendications précédentes.


**Patentansprüche**

1. Zelle zum Detektieren von Photonen, die Tunneleffekt-Supraleitereinrichtungen umfasst, die gemäß einem zweidimensionalen Netz arrangiert und auf einem gemeinsamen Substrat angeordnet sind, wobei jede Supraleitereinrichtung einen supraleitenden Tunnelübergang aufweist, der elektrisch mit einem Grundflächen-Verbindungsbereich und mit einem obenliegenden Verbindungsbereich verbunden ist, **dadurch gekennzeichnet, dass** die Supraleitereinrichtungen durch einen Grabenbereich (11) voneinander getrennt sind, der sich bis einschließlich zum Grundflächen-Verbindungsbereich erstreckt, so dass eine physikalische Trennung zwischen benachbarten Supraleitereinrichtungen gewährleistet ist und einzelne Grundflächenverbindungsbereiche (2) abgegrenzt sind, die zwischen dem Übergang (3, 4, 5) und dem Substrat (1) angeordnet sind, und dadurch, dass wenigstens ein einzelner Grundflächen-Verbindungsbereich (2) durch einen örtlichen Brückenbereich (20) elektrisch mit wenigstens einem Grundflächen-Verbindungsbereich einer benachbarten Supraleitereinrichtung verbunden ist.

2. Zelle nach Anspruch 1, **dadurch gekennzeichnet, dass** wenigstens ein Brückenbereich (20) zwei Ansätze (21) aufweist, deren Enden untereinander durch einen örtlichen Bereich (23) elektrisch verbunden sind.

3. Zelle nach Anspruch 2, **dadurch gekennzeichnet, dass** der örtliche Bereich (23) aus einem Material hergestellt ist, das eine Breite des verbotenen Bandes aufweist, die größer oder gleich derjenigen des Materials ist, das die Grundflächen-Verbindungsbereiche (2) und die Ansätze (21) bildet.

4. Zelle gemäß einem der Ansprüche 1 bis 3, **dadurch gekennzeichnet, dass** wenigstens ein Brückenbereich (20, 23) eine Breite aufweist, die zwischen 0,5 μ und 2 μ, und vorzugsweise zwischen 0,5 μ und 1 μ liegt.

5. Zelle nach einem der vorhergehenden Ansprüche, **dadurch gekennzeichnet, dass** die Breite von wenigstens einem Brückenbereich (20, 23) kleiner als oder gleich groß wie die Breite des Grabenbereichs (11) ist.

6. Zelle nach einem der vorhergehenden Ansprüche, **dadurch gekennzeichnet, dass** der Verbindungsbereich (2) jeder Supraleitereinrichtung (10) durch einen Brückenbereich (20) mit den Verbindungsbereichen (2) jeder an ihn angrenzenden Supraleitereinrichtung (10) verbunden ist.

7. Zelle nach einem der vorhergehenden Ansprüche, **dadurch gekennzeichnet, dass** die Supraleitereinrichtungen (10) Plateaus der Form eines Vierecks sind und dadurch, dass die Supraleitereinrichtungen (10), die in benachbarten Reihen angeordnet sind, in Bezug auf die anderen um eine Distanz verschoben sind, die kleiner als ihre Schrittweite (P) ist, und dadurch, dass die obenliegenden Verbindungsbereiche (6) leitende Enden aufweisen, die in der Verlängerung der Diagonalen der Vierecke angeordnet sind.

8. Zelle nach einem der vorhergehenden Ansprüche, **dadurch gekennzeichnet, dass** die supraleitenden Einrichtungen (10) Plateaus mit einer quadratischen Form bilden.

**9.** Abtastvorrichtung, **dadurch gekennzeichnet, dass** sie eine Zelle zum Erfassen gemäß einem der vorhergehenden Ansprüche aufweist.

**Claims**

**1.** A detector cell comprising tunnel-effect superconductive devices organized in a two-dimensional array and deposited on a common substrate, each superconductive device comprising a tunnel-effect superconductive junction electrically connected to a bottom connection area and to a top connection area, the cell being **characterized in that** the superconductive devices are separated from one another by a trench region (11) extending down to and including the bottom connection area so as to provide physical separation between adjacent semiconductor devices and so as to define individual bottom connection areas (2) disposed between respective junctions (3, 4, 5) and the substrate (1), and **in that** at least one individual bottom connection area (2) is electrically connected to at least one bottom connection area of an adjacent superconductive device by a localized bridge region (20).

**2.** A cell according to claim 1, **characterized in that** at least one said bridge region (20) comprises two appendices (21) whose ends are electrically interconnected by a localized area (23).

**3.** A cell according to claim 2, **characterized in that** said localized bridge (23) is made of a material having a forbidden bandwidth greater than or equal to that of the material constituting said bottom connection areas (2) and said appendices (21).

**4.** A cell according to any one of claims 1 to 3, **characterized in that** at least one of said bridge regions (20, 23) is of a width lying in the range 0.5 μm to 2 μm and preferably in the range 0.5 μm to 1 μm.

**5.** A cell according to any preceding claim, **characterized in that** the width of at least one of said bridge regions (20, 23) is less than or equal to the width of said trench region (11).

**6.** A cell according to any preceding claim, **characterized in that** the bottom connection area (2) of each superconductive device (10) is connected by respective ones of said bridge regions (20) to the bottom connection areas (2) of each superconductive device (10) adjacent thereto.

**7.** A cell according to any preceding claim, **characterized in that** the superconductive devices (10) are mesas of quadrilateral shape, and **in that** the superconductive devices (10) situated in adjacent rows are offset from one another by a distance that is less than their pitch (P), and **in that** the top connection areas (6) have conductive terminations disposed in line with the diagonals of said quadrilaterals.

**8.** A cell according to any preceding claim, **characterized in that** the superconductive devices (10) form mesas that are square in shape.

**9.** A picture-taking device **characterized in that** it includes a detector cell according to any preceding claim.

FIG.1

FIG.2a

FIG.2b

FIG.2c

FIG.2d

FIG.3

FIG.4a

FIG.4b